# EUROPEAN PATENT APPLICATION

(11) **EP 4 255 153 A1**
(43) Date of publication of application: **04.10.2023**
(21) Application number: 23158966.4
(22) Date of filing: 28.02.2023
(51) Int. Cl.: H10K 59/121, H10K 102/00, H10K 59/35, H10K 59/80

(54) **DISPLAY PANEL AND DISPLAY DEVICE INCLUDING THE SAME**

(30) Priority: 30.03.2022 KR 20220039801
(71) Applicant: Samsung Display Co., Ltd., Yongin-si, Gyeonggi-do 17113 (KR)
(72) Inventor: KIM, Kiwook, Hwaseong-si (KR); KIM, Kwang-Min, Seoul (KR); HWANG, Do Yeon, Seoul (KR)
(74) Representative: Walaski, Jan Filip

(57) **Abstract**

A display panel includes a pixel unit including a plurality of pixels which emits light of different colors from each other, and a light blocking element disposed on the pixel unit and blocking a portion of light emitted from each of the plurality of pixels. Each of the plurality of pixels includes a pixel circuit, a first light emitting element electrically connected to the pixel circuit, and a second light emitting element electrically connected to the pixel circuit, where the second light emitting element emits light of the same color as light emitted from the first light emitting element. The light blocking element blocks a portion of light emitted from the first light emitting element and traveling in a first direction, and blocks a portion of light emitted from the second light emitting element and traveling in a second direction opposite to the first direction.

## Description

### BACKGROUND

### 1. Field

Embodiments of the invention relate generally to a display panel and a display device including the display panel.

### 2. Discussion of the Related Art

A flat panel display device is being used as a display device to replace a cathode ray tube display device due to characteristics such as light weight and thinness. Representative examples of such flat panel display device include a liquid crystal display device and an organic light emitting display device.

The display device typically includes a display panel and a panel driver. In general, the display panel is manufactured to have a wide viewing angle, but it may be desired to temporarily drive the display panel with a narrow viewing angle so that no one other than the user can see the screen in a public place.

### SUMMARY

Embodiments provide a display device with improved display quality.

A display panel according to an embodiment includes a pixel unit including a plurality of pixels which emits light of different colors from each other, and a light blocking element disposed on the pixel unit, where the light blocking element blocks a portion of light emitted from each of the plurality of pixels. In such an embodiment, each of the plurality of pixels includes a pixel circuit, a first light emitting element electrically connected to the pixel circuit, and a second light emitting element electrically connected to the pixel circuit, where the second light emitting element emits light of the same color as light emitted from the first light emitting element. In such an embodiment, the light blocking element blocks a portion of light emitted from the first light emitting element and traveling in a first direction, and blocks a portion of light emitted from the second light emitting element and traveling in a second direction opposite to the first direction.

In an embodiment, a pixel electrode of the first light emitting element may be spaced apart from a pixel electrode of the second light emitting element.

In an embodiment, in a plan view, the light blocking element may surround each of the first light emitting element and the second light emitting element, and a first distance between an edge in the first direction of the first light emitting element and the light blocking element may be less than a second distance between an edge in the second direction of the first light emitting element and the light blocking element.

In an embodiment, in the plan view, a third distance between an edge in the first direction of the second light emitting element and the light blocking element may be greater than a fourth distance between an edge in the second direction of the second light emitting element and the light blocking element.

In an embodiment, the plurality of pixels may include a first pixel, a second pixel, and a third pixel, and a first light emitting element of the first pixel, a first light emitting element of the second pixel, and a first light emitting element of the third pixel may be respectively placed at vertices of an imaginary triangle.

In an embodiment, a second light emitting element of the first pixel, a second light emitting element of the second pixel, and a second light emitting element of the third pixel may be respectively placed at vertices of another imaginary triangle.

In an embodiment, a first emission signal, which controls an operation of the first light emitting element, may be applied to the pixel circuit, and a second emission signal, which controls an operation of the second light emitting element, may be applied to the pixel circuit.

In an embodiment, the pixel circuit may include a first transistor including a gate electrode connected to a first node, a first electrode connected to a second node, and a second electrode connected to a third node, a second transistor including a gate electrode to which a data input gate signal is applied, a first electrode to which a data voltage is applied, and a second electrode connected to the second node, a third transistor including a gate electrode to which the data input gate signal is applied, a first electrode connected to the first node, and a second electrode connected to the third node, a fourth transistor including a gate electrode to which a data initialization gate signal is applied, a first electrode to which a first initialization signal is applied, and a second electrode connected to the first node, a fifth transistor including a gate electrode to which the first emission signal is applied, a first electrode to which a high power voltage is applied, and a second electrode connected to the second node, a sixth transistor including a gate electrode to which the first emission signal is applied, a first electrode connected to the third node, and a second electrode connected to a pixel electrode of the first light emitting element, a seventh transistor including a gate electrode to which a light emitting element initialization gate signal is applied, a first electrode to which a second initialization signal is applied, and a second electrode connected to the pixel electrode of the first light emitting element, an eight transistor including a gate electrode to which the second emission signal is applied, a first electrode to which the high power voltage is applied, and a second electrode connected to the second node, a ninth transistor including a gate electrode to which the second emission signal is applied, a first electrode connected to the third node, and a second electrode connected to a pixel electrode of the second light emitting element, a tenth transistor including a gate electrode to which the light emitting element initialization gate signal is applied, a first electrode to which the second initialization signal is applied, and a second electrode connected to the pixel electrode of the second light emitting element, and a storage capacitor including a first electrode to which the high power voltage is applied and a second electrode connected to the first node.

In an embodiment, the display panel may further include a first global signal line to which a first global signal is applied, where the first global signal line has a mesh shape, and the first global signal controls an operation of the first light emitting element, and a second global signal line to which a second global signal is applied, where the second global signal line has a mesh shape, and the second global signal controls an operation of the second light emitting element.

In an embodiment, the pixel circuit may include a first transistor including a gate electrode connected to a first node, a first electrode connected to a second node, and a second electrode connected to a third node, a second transistor including a gate electrode to which a data input gate signal is applied, a first electrode to which a data voltage is applied, and a second electrode connected to the second node, a third transistor including a gate electrode to which the data input gate signal is applied, a first electrode connected to the first node, and a second electrode connected to the third node, a fourth transistor including a gate electrode to which a data initialization gate signal is applied, a first electrode to which a first initialization signal is applied, and a second electrode connected to the first node, a fifth transistor including a gate electrode to which an emission signal is applied, a first electrode to which a high power voltage is applied, and a second electrode connected to the second node, a sixth transistor including a gate electrode to which the emission signal is applied, a first electrode connected to the third node, and a second electrode connected to a fourth node, a seventh transistor including a gate electrode to which a light emitting element initialization gate signal is applied, a first electrode to which a second initialization signal is applied, and a second electrode connected to a pixel electrode of the first light emitting element, an eight transistor including a gate electrode to which the first global signal is applied, a first electrode connected to the fourth node, and a second electrode connected to the pixel electrode of the first light emitting element, a ninth transistor including a gate electrode to which the second global signal is applied, a first electrode connected to the fourth node, and a second electrode connected to a pixel electrode of the second light emitting element, a tenth transistor including a gate electrode to which the light emitting element initialization gate signal is applied, a first electrode to which the second initialization signal is applied, and a second electrode connected to the pixel electrode of the second light emitting element, and a storage capacitor including a first electrode to which the high power voltage is applied and a second electrode connected to the first node.

A display device according to an embodiment includes a display panel including a pixel unit comprising a plurality of pixels which emits light of different colors from each other, and a light blocking element disposed on the pixel unit, where the light blocking element blocks a portion of light emitted from each of the plurality of pixels, a gate driver which provides a gate signal to the display panel, a data driver which provides a data voltage to the display panel, and an emission driver which provides an emission signal to the display panel. In such an embodiment, each of the plurality of pixels includes a pixel circuit, a first light emitting element electrically connected to the pixel circuit, and a second light emitting element electrically connected to the pixel circuit, where the second light emitting elements emits light of the same color as light emitted from the first light emitting element. In such an embodiment, the light blocking element blocks a portion of light emitted from the first light emitting element and traveling in a first direction, and blocks a portion of light emitted from the second light emitting element and traveling in a second direction opposite to the first direction.

In an embodiment, a pixel electrode of the first light emitting element may be spaced apart from a pixel electrode of the second light emitting element.

In an embodiment, in a plan view, the light blocking element may surround each of the first light emitting element and the second light emitting element, and a first distance between an edge in the first direction of the first light emitting element and the light blocking element may be less than a second distance between an edge in the second direction of the first light emitting element and the light blocking element.

In an embodiment, in the plan view, a third distance between an edge in the first direction of the second light emitting element and the light blocking element may be greater than a fourth distance between an edge in the second direction of the second light emitting element and the light blocking element.

In an embodiment, the plurality of pixels may include a first pixel, a second pixel, and a third pixel, and a first light emitting element of the first pixel, a first light emitting element of the second pixel, and a first light emitting element of the third pixel may be respectively placed at vertices of an imaginary triangle.

In an embodiment, a second light emitting element of the first pixel, a second light emitting element of the second pixel, and a second light emitting element of the third pixel may be respectively placed at vertices of another imaginary triangle.

In an embodiment, the emission signal may include a first emission signal which controls an operation of the first light emitting element, and a second emission signal which controls an operation of the second light emitting element.

In an embodiment, the pixel circuit may include a first transistor including a gate electrode connected to a first node, a first electrode connected to a second node, and a second electrode connected to a third node, a second transistor including a gate electrode to which a data input gate signal is applied, a first electrode to which a data voltage is applied, and a second electrode connected to the second node, a third transistor including a gate electrode to which the data input gate signal is applied, a first electrode connected to the first node, and a second electrode connected to the third node, a fourth transistor including a gate electrode to which a data initialization gate signal is applied, a first electrode to which a first initialization signal is applied, and a second electrode connected to the first node, a fifth transistor including a gate electrode to which the first emission signal is applied, a first electrode to which a high power voltage is applied, and a second electrode connected to the second node, a sixth transistor including a gate electrode to which the first emission signal is applied, a first electrode connected to the third node, and a second electrode connected to a pixel electrode of the first light emitting element, a seventh transistor including a gate electrode to which a light emitting element initialization gate signal is applied, a first electrode to which a second initialization signal is applied, and a second electrode connected to the pixel electrode of the first light emitting element, an eight transistor including a gate electrode to which the second emission signal is applied, a first electrode to which the high power voltage is applied, and a second electrode connected to the second node, a ninth transistor including a gate electrode to which the second emission signal is applied, a first electrode connected to the third node, and a second electrode connected to a pixel electrode of the second light emitting element, a tenth transistor including a gate electrode to which the light emitting element initialization gate signal is applied, a first electrode to which the second initialization signal is applied, and a second electrode connected to the pixel electrode of the second light emitting element, and a storage capacitor including a first electrode to which the high power voltage is applied and a second electrode connected to the first node.

In an embodiment, the display panel may further include a first global signal line to which a first global signal is applied, where the first global signal line has a mesh shape, and the first global signal controls an operation of the first light emitting element, and a second global signal line to which a second global signal is applied, where the second global signal line has a mesh shape, and the second global signal controls an operation of the second light emitting element.

In an embodiment, the pixel circuit may include a first transistor including a gate electrode connected to a first node, a first electrode connected to a second node, and a second electrode connected to a third node, a second transistor including a gate electrode to which a data input gate signal is applied, a first electrode to which a data voltage is applied, and a second electrode connected to the second node, a third transistor including a gate electrode to which the data input gate signal is applied, a first electrode connected to the first node, and a second electrode connected to the third node, a fourth transistor including a gate electrode to which a data initialization gate signal is applied, a first electrode to which a first initialization signal is applied, and a second electrode connected to the first node, a fifth transistor including a gate electrode to which an emission signal is applied, a first electrode to which a high power voltage is applied, and a second electrode connected to the second node, a sixth transistor including a gate electrode to which the emission signal is applied, a first electrode connected to the third node, and a second electrode connected to a fourth node, a seventh transistor including a gate electrode to which a light emitting element initialization gate signal is applied, a first electrode to which a second initialization signal is applied, and a second electrode connected to a pixel electrode of the first light emitting element, an eight transistor including a gate electrode to which the first global signal is applied, a first electrode connected to the fourth node, and a second electrode connected to the pixel electrode of the first light emitting element, a ninth transistor including a gate electrode to which the second global signal is applied, a first electrode connected to the fourth node, and a second electrode connected to a pixel electrode of the second light emitting element, a tenth transistor including a gate electrode to which the light emitting element initialization gate signal is applied, a first electrode to which the second initialization signal is applied, and a second electrode connected to the pixel electrode of the second light emitting element, and a storage capacitor including a first electrode to which the high power voltage is applied and a second electrode connected to the first node.

In the display device according to embodiments of the invention, each of a plurality of pixels may include a pixel circuit, a first light emitting element electrically connected to the pixel circuit, and a second light emitting element electrically connected to the pixel circuit and which emits light of the same color as light emitted from the first light emitting element. In such embodiments, the first light emitting element may be controlled by a first signal, and the second light emitting element may be controlled by a second signal. A light blocking element may be disposed on the first light emitting element and the second light emitting element. The light blocking element may block a portion of light emitted from the first light emitting element and traveling in a first direction, and blocks a portion of light emitted from the second light emitting element and traveling in a second direction opposite to the first direction. Accordingly, even when an image is displayed at a narrow viewing angle in which a viewing angle in a specific direction is limited, resolution of the image may not be reduced.

### BRIEF DESCRIPTION OF THE DRAWINGS

The accompanying drawings, which are included to provide a further understanding of the invention and are incorporated in and constitute a part of this specification, illustrate embodiments of the invention together with the description.
FIG. 1 is a block diagram illustrating a display device according to an embodiment.
FIG. 2 is a circuit diagram illustrating a pixel included in the display device of FIG. 1.
FIG. 3 is a plan view illustrating an embodiment of a pixel unit and a light blocking element included in the display device of FIG. 1.
FIG. 4 is a cross-sectional view taken along line I-I' of FIG. 3.
FIG. 5 is a cross-sectional view taken along line II-II' of FIG. 5.
FIG. 6, FIG. 7, and FIG. 8 are plan views illustrating alternative embodiments of a pixel unit and a light blocking element included in the display device of FIG. 1.
FIG. 9, FIG. 10, FIG. 11, FIG. 12, FIG. 13, FIG. 14, FIG. 15, FIG. 16, FIG. 17, FIG. 18, and FIG. 19 are diagrams illustrating layers of the pixel of FIG. 2.
FIG. 20 is a cross-sectional view taken along line III-III' of FIG. 19.
FIG. 21 is a circuit diagram illustrating a pixel included in a display device according to an alternative embodiment.
FIG. 22 is a plan view illustrating a display panel according to an alternative embodiment.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Illustrative, non-limiting embodiments will be more clearly understood from the following detailed description in conjunction with the accompanying drawings.

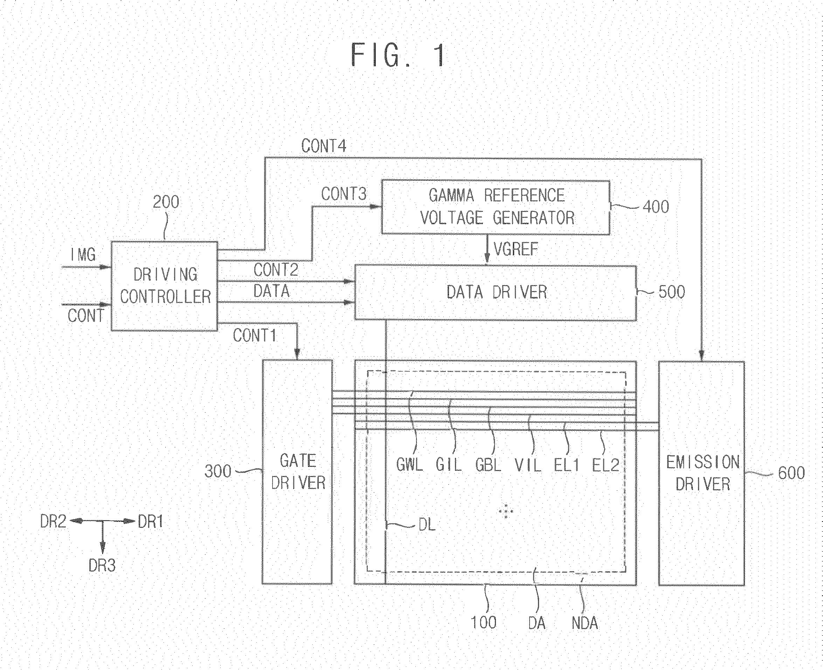

FIG. 1 is a block diagram illustrating a display device according to an embodiment.

Referring to FIG. 1, a display device according to an embodiment may include a display panel 100 and a panel driver. The panel driver may include a driving controller 200, a gate driver 300, a gamma reference voltage generator 400, a data driver 500, and an emission driver 600.

The display panel 100 may include a display area DA and a peripheral area NDA disposed adjacent to the display area DA.

The display panel 100 may include a plurality of gate lines GWL, GIL, and GBL, a plurality of data lines DA, a plurality of first emission lines EL1, a plurality of second emission lines EL2, and a plurality of pixels. The plurality of pixels may be electrically connected to the plurality of gate lines GWL, GIL, and GBL, the plurality of data lines DA, the plurality of first emission lines EL1, and the plurality of second emission lines EL2. In an embodiment, each of the plurality of gate lines GWL, GIL, and GBL, the plurality of first emission lines EL1, and the plurality of second emission lines EL2 may extend along a first direction DR1 (or, along a second direction DR2 opposite to the first direction DR1). Each of the plurality of data lines DL may extend along a third direction DR3 crossing the first direction DR1.

In an embodiment, the display panel 100 may further include a plurality of initialization lines VIL that provides an initialization signal to the plurality of pixels. In an embodiment, the plurality of initialization lines VIL may extend along the first direction DR1.

The driving controller 200 may receive an input image data IMG and an input control signal CONT from an external device (not shown). In an embodiment, for example, the input image data IMG may include a red image data, green image data, and a blue image data. In an alternative embodiment, for example, the input image data IMG may further include white image data. In another alternative embodiment, for example, the input image data IMG may include a magenta image data, yellow image data, and a cyan image data. The input control signal CONT may include a vertical sync signal and a horizontal sync signal.

The driving controller 200 may generate a first control signal CONT1, a second control signal CONT2, a third control signal CONT3, a fourth control signal CONT4, and a data signal DATA based on the input image data IMG and the input control signal.

The driving controller 200 may generate the first control signal CONT1 for controlling the gate driver 300 based on the input control signal CONT. The driving controller 200 may provide the first control signal CONT1 to the gate driver 300. The first control signal CONT1 may include a vertical initiation signal and a gate clock signal.

The driving controller 200 may generate the second control signal CONT2 for controller the data driver 500 based on the input control signal CONT. The driving controller 200 may provide the second control signal CONT2 to the data driver 500. The second control signal CONT2 may include a horizontal initiation signal and a load signal.

The driving controller 200 may generate the data signal DATA based on the input image data IMG. The driving controller 200 may provide the data signal DATA to the data driver 500.

The driving controller 200 may generate the third control signal CONT3 for controlling the gamma reference voltage generator 400 based on the input control signal CONT. The driving controller 200 may provide the third control signal CONT3 to the gamma reference voltage generator 400.

The driving controller 200 may generate the fourth control signal CONT4 for controlling the emission driver 600 based on the input controlling signal CONT. The driving controller 200 may provide the fourth control signal CONT4 to the emission driver 600.

The gate driver 300 may generate gate signals for driving the plurality of gate lines GWL, GIL, and GBL in response to the first control signal CONT1 received from the driving controller 200. The gate driver 300 may provide the gate signals to the plurality of gate lines GWL, GIL, and GBL.

In an embodiment, the gate driver 300 may generate initialization signals for driving the plurality of initialization lines VIL in response to the first control signal CONT1 received from the driving controller 200. The gate driver 300 may provide the initialization signals to the initialization lines VIL.

The gamma reference voltage generator 400 may generate a gamma reference voltage VGREF in response to the third control signal CONT3 received from the driving controller 200. The gamma reference voltage generator 400 may provide the gamma reference voltage VGREF to the data driver 500. The gamma reference voltage VGREF may have a value corresponding to a value of the data signal DATA.

The gamma reference voltage generator 400 may be disposed in the driving controller 200, or may be disposed in the data driver 500.

The data driver 500 may receive the second control signal CONT2 and the data signal DATA from the driving controller 200, and may receive the gamma reference voltage VGREF from the gamma reference voltage generator 400. The data driver 500 may convert the data signal DATA into an analog data voltage using the gamma reference voltage VGREF. The data driver 500 may provide the data voltage to the data voltage to the data line DL.

The emission driver 600 may generate emission signals for driving the plurality of first and second emission lines EL1 and EL2 in response to the fourth control signal CONT4 received from the driving controller 200. The emission driver 600 may provide the emission signals to the plurality of first and second emission lines EL1 and EL2.

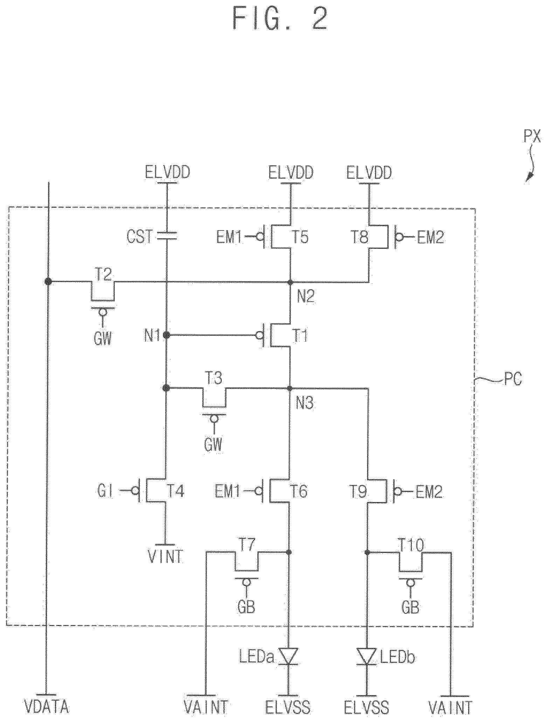

FIG. 2 is a circuit diagram illustrating a pixel included in the display device of FIG. 1.

Referring to FIG. 1 and FIG. 2, each of the plurality of pixels PX included in the display panel 100 may include a pixel circuit PC, a first light emitting element Leda, and a second light emitting element Led. The pixel circuit PC may provide a driving current to the first light emitting element LEDa and the second light emitting element LEDb. The first light emitting element LEDa and the second light emitting element LEDb may emit light of the same color as each other based on the driving current.

In an embodiment, the pixel circuit PC may include first to tenth transistors T1, T2, T3, T4, T5, T6, T7, T8, T9, and T10, and a storage capacitor CST, but the invention is not limited thereto.

The first transistor T1 may include a gate electrode connected to a first node N1, a first electrode connected to a second node N2, and a second electrode connected to a third node N3. In an embodiment, the first transistor T1 may be a P-type thin film transistor.

The second transistor T2 may include a gate electrode to which a data write gate signal GW is applied, a first electrode to which a data voltage VDATA is applied, and a second electrode connected to the second node N2. In an embodiment, the second transistor T2 may be a P-type thin film transistor.

The third transistor T3 may include a gate electrode to which the data write gate signal GW is applied, a first electrode connected to the first node N1, and a second electrode connected to the third node N3. In an embodiment, the third transistor T3 may be a P-type thin film transistor.

The fourth transistor T4 may include a gate electrode to which a data initialization gate signal GI is applied, a first electrode to which a first initialization signal VINT is applied, and a second electrode connected to the first node N1. In an embodiment, the fourth transistor T4 may be a P-type thin film transistor.

The fifth transistor T5 may include a gate electrode to which a first emission signal EM1 is applied, a first electrode to which a high power voltage ELVDD is applied, and a second electrode connected to the second node N2. In an embodiment, the fifth transistor T5 may be a P-type thin film transistor.

The sixth transistor T6 may include a gate electrode to which the first emission signal EM1 is applied, a first electrode connected to the third node N3, and a second electrode connected to a first electrode (for example, a pixel electrode) of the first light emitting element LEDa. In an embodiment, the sixth transistor T6 may be a P-type thin film transistor.

The seventh transistor T7 may include a gate electrode to which a light emitting element initialization gate signal GB is applied, a first electrode to which a second initialization signal VAINT is applied, and a second electrode connected to the first electrode of the first light emitting element LEDa. In an embodiment, the seventh transistor T7 may be a P-type thin film transistor.

The eight transistor T8 may include a gate electrode to which a second emission signal EM2 is applied, a first electrode to which the high power voltage ELVDD is applied, and a second electrode connected to the second node N2. In an embodiment, the eight transistor T8 may be a P-type thin film transistor.

The ninth transistor T9 may include a gate electrode to which the second emission signal EM2 is applied, a first electrode connected to the third node N3, and a second electrode connected to a first electrode (for example, a pixel electrode) of the second light emitting element LEDb. In an embodiment, the ninth transistor T9 may be a P-type thin film transistor.

The tenth transistor T10 may include a gate electrode to which the light emitting element initialization gate signal GB is applied, a first electrode to which the second initialization signal VAINT is applied, and a second electrode connected to the first electrode of the second light emitting element LEDb. In an embodiment, the tenth transistor T10 may be a P-type thin film transistor.

The storage capacitor CST may include a first electrode to which the high power voltage ELVDD is applied, and a second electrode connected to the first node N1.

The first light emitting element LEDa may include the first electrode and a second electrode (for example, a common electrode) to which the low power voltage ELVSS is applied . Operation of the first light emitting element LEDa may be controlled by the first emission signal EM1. In an embodiment, for example, when the first emission signal EM1 has an activation level, the fifth transistor T5 and the sixth transistor T6 may be turned on. Also, the first transistor T1 may be turned on by the data voltage VDATA. The driving current may flow in order of the fifth transistor T5, the first transistor T1, and the sixth transistor T6 to drive the first light emitting element LEDa.

The second light emitting element LEDb may include the first electrode and a second electrode (for example, a common electrode) to which the low power voltage ELVSS is applied. Operation of the second light emitting element LEDb may be controlled by the second emission signal EM2. In an embodiment, for example, when the second emission signal EM2 has an activation level, the eight transistor T8 and the ninth transistor T9 may be turned on. Also, the first transistor T1 may be turned on by the data voltage VDATA. The driving current may flow in order of the eight transistor T8, the first transistor T1, and the ninth transistor T9 to drive the second light emitting element LEDb.

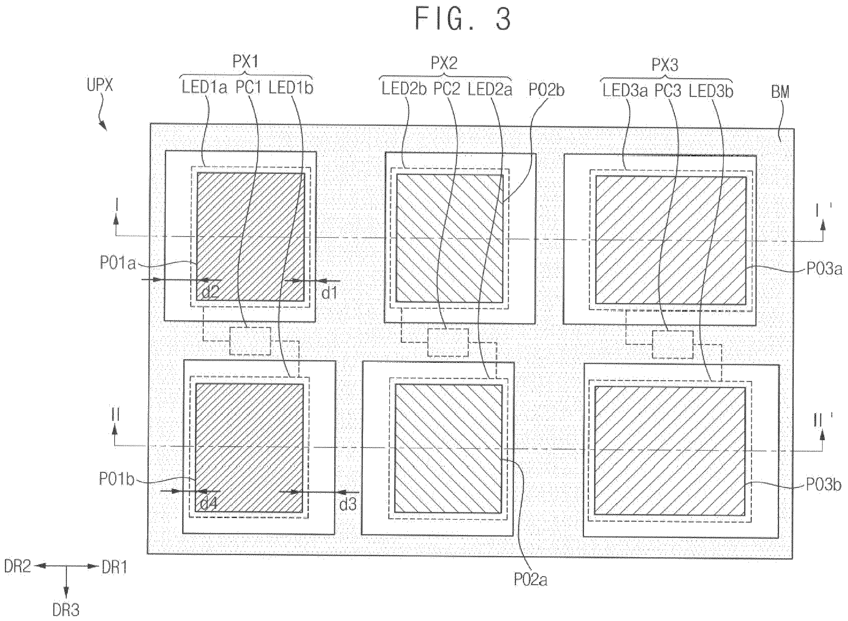

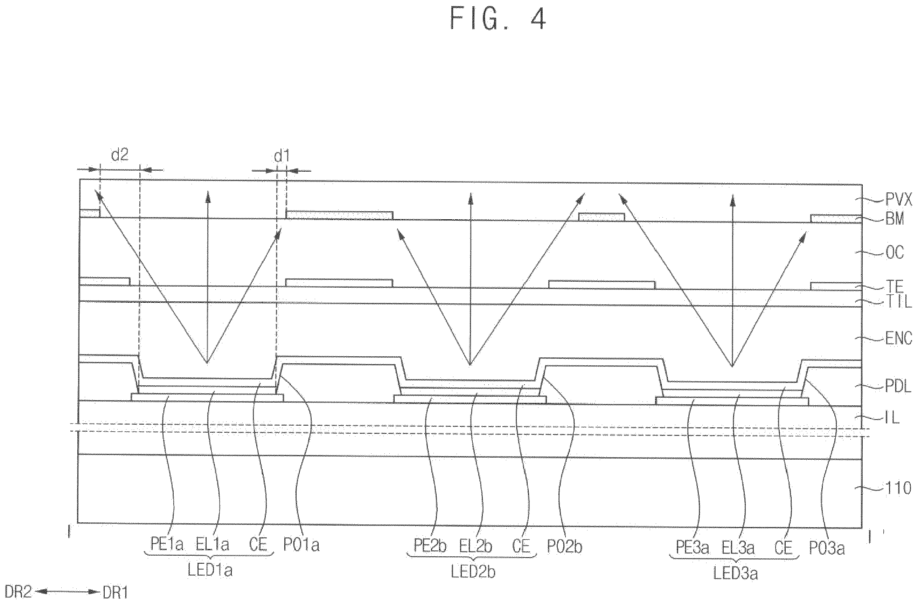

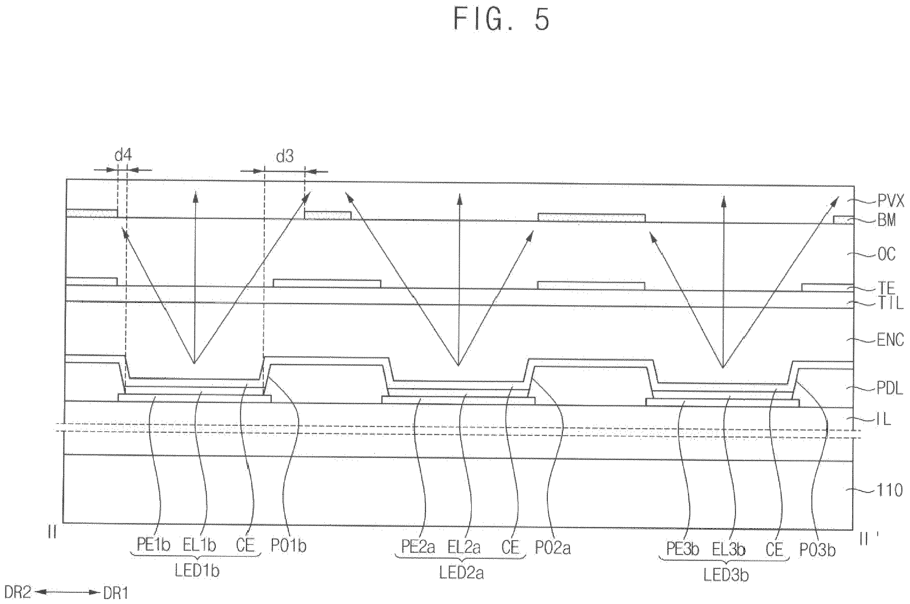

FIG. 3 is a plan view illustrating an embodiment of a pixel unit and a light blocking element included in the display device of FIG. 1. FIG. 4 is a cross-sectional view taken along line I-I' of FIG. 3. FIG. 5 is a cross-sectional view taken along line II-II' of FIG. 5.

Referring to FIG. 1, FIG. 2, FIG. 3, FIG. 4, and FIG. 5, an embodiment of the display panel 100 may include a substrate 110, the plurality of pixels PX, an insulation structure IL, a pixel defining layer PDL, an encapsulation layer ENC, a touch insulation layer TIL, a touch electrode layer TE, an overcoating layer OC, a light blocking element BM, and a passivation layer PVX.

The substrate 110 may be an insulation substrate including or formed of a transparent or opaque material. In an embodiment, the substrate 110 may include a glass. In this case, the display panel 100 may be a rigid display panel. In an alternative embodiment, the substrate 110 may include a plastic. In such an embodiment, the display panel 100 may be a flexible display panel.

The plurality of pixels PX may be disposed on the substrate 110. The plurality of pixels PX may include a first pixels PX1, a second pixel PX2, and a third pixel PX3 emitting light of different colors from each other. In an embodiment, for example, the first pixel PX1 may emit light of first color, the second pixel PX2 may emit light of second color, and the third pixel PX3 may emit light of third color. In an embodiment, for example, the first color may be red, the second color may be green, and the third color may be blue, but the invention is not limited thereto. The circuit diagram illustrated in FIG. 2 may correspond to any one of the first to third pixels PX1, PX2, and PX3 of FIG. 3.

In an embodiment, the first to third pixels PX1, PX2, and PX3 adjacent to each other may constitute or collectively define one pixel unit UPX. In an embodiment, for example, in the display panel 100, a plurality of pixel unit UPX may be arranged in a matrix form along the first direction DR1 and the third direction DR3.

The first pixel PX1 may include a pixel circuit PC1, a first light emitting element LED1a, and a second light emitting element LED 1b. The pixel circuit PC1 may provide a driving current to the first light emitting element LED1a and the second light emitting element LEDb.

The first light emitting element LED1a of the first pixel PX1 may include a pixel electrode PE1a, a light emitting layer EL1a, and the common electrode CE. The first light emitting layer EL1a of the first pixel PX1 may be electrically connected to the first pixel circuit PC1, and may emit light of the first color (for example, red light). The second light emitting element LED1b of the first pixel PX1 may include a pixel electrode PE1b, a light emitting layer EL1b, and the common electrode CE. The second light emitting element LED1b of the first pixel PX1 may be electrically connected to the first pixel circuit PC1, and may emit light of the first color (for example, red light).

The second pixel PX2 may include a pixel circuit PC2, a first light emitting element LED2a, and a second light emitting element LEDb. The first light emitting element LED2a of the second pixel PX2 may include a pixel electrode PE2a, a light emitting layer EL2a, and the common electrode CE. The first light emitting element LED2a of the second pixel PX2 may be electrically connected to the pixel circuit PC2, and may emit light of the second color (for example, green light). The second light emitting element LED2b of the second pixel PX2 may include a pixel electrode PE2b, a light emitting layer EL2b, and a common electrode CE. The second light emitting element LED2b of the second pixel PX2 may be electrically connected to the pixel circuit PC2, and may emit light of the second color (for example, green light).

The third pixel PX3 may include a pixel circuit PC3, a first light emitting element LED3a, and a second light emitting element LED3b. The first light emitting element LED3a of the third pixel PX3 may include a pixel electrode PE3a, a light emitting layer LE3a, and the common electrode CE. The first light emitting element LED3a of the third pixel PX3 may be electrically connected to the pixel circuit PC3, and may emit light of the third color (for example, blue light). The second light emitting element LED3b of the third pixel PX3 may include a pixel electrode PE3b, a light emitting layer EL3b, and the common electrode CE. The second light emitting element LED3b of the third pixel PX3 may be electrically connected to the pixel circuit PC3, and may emit light of third color (for example, blue light).

In an embodiment, as shown in FIG. 3, the first light emitting element LED1a of the first pixel PX1, the second light emitting element LED2b of the second pixel PX2, and the first light emitting element LED3a of the third pixel PX3 may be sequentially disposed along the first direction DR1. The second light emitting element LED1b of the first pixel PX1 may be disposed in the third direction DR3 of the first light emitting element LED1a of the first pixel PX1, the first light emitting element LED2a of the second pixel PX2 may be disposed in the third direction DR3 of the second light emitting element LED2b of the second pixel PX2, and the second light emitting element LED3b of the third pixel PX3 may be disposed in the third direction DR3 of the first light emitting element LED3a of the third pixel PX3. That is, the first light emitting elements LED1a, LED2a, and LED3a may be disposed at vertices of an imaginary triangle. In addition, the second light emitting elements LED1b, LED2b, and LED3b may be disposed at vertices of a different imaginary triangle.

In an embodiment, as described above, operation of the first light emitting elements LED1a, LED2a, and LED3a may be controlled by the first emission signal EM1, and operation of the second light emitting elements LED1b, LED2b, and LED3b may be controlled by the second emission signal EM2.

In an embodiment, for example, when the first emission signal EM1 has an activation level and the second emission signal EM2 has an inactivation level, the first light emitting elements LED1a, LED2a, and LED3a may be turned on, and the second light emitting elements LED1b, LED2b, and LED3b may be turned off.

In an embodiment, for example, when the first emission signal EM1 has an inactivation level and the second emission signal EM2 has an activation level, the first light emitting elements LED1a, LED2a, and LED3a may be turned off, and the second light emitting elements LED1b, LED2b, and LED3b may be turned on.

In an embodiment, for example, when the first emission signal EM1 and the second emission signal EM2 have an activation level, the first light emitting elements LED1a, LED2a, and LED3a and the second light emitting elements LED1b, LED2b, and LED3b may be turned on.

In an embodiment, for example, when the first emission signal EM1 and the second emission signal EM2 have an inactivation level, the first light emitting elements LED1a, LED2a, and LED3a and the second light emitting elements LED1b, LED2b, and LED3b may be turned off.

The insulation structure IL may cover the pixel circuits PC1, PC2, and PC3. The insulation structure IL may include at least one inorganic insulation layer and at least one organic insulation layer.

The pixel electrodes PE1a, PE1b, PE2a, PE2b, PE3a, and PE3b including a conductive material may be disposed on the insulation structure IL. The pixel electrodes PE1a, PE1b, PE2a, PE2b, PE3a, and PE3b may be physically separated from each other. The pixel electrodes PE1a and PE1b may be electrically connected to the pixel circuit PC1 through contact holes defined or formed in the insulation structure IL. The pixel electrodes PE2a and PE2b may be electrically connected to the pixel circuit PC2 through contact holes defined or formed in the insulation structure IL. The pixel electrodes PE3a and PE3b may be electrically connected to the pixel circuit PC3 through contact holes defined or formed in the insulation structure IL.

The pixel defining layer PDL may be disposed on the pixel electrodes PE1a, PE1b, PE2a, PE2b, PE3a, and PE3b. The pixel defining layer PDL may include an organic insulation material. The pixel defining layer PDL may define pixel openings PO1a, PO1b, PO2a, PO2b, PO3a, and PO3b exposing at least a portion of the pixel electrodes PE1a, PE1b, PE2a, PE2b, PE3a, and PE3b.

The light emitting layers EL1a and EL1b for emitting light of the first color (for example, red light) may be disposed on the pixel electrodes PE1a and PE1b of the first pixel PX1 exposed by the pixel openings PO1a and PO1b. The light emitting layers EL2a and EL2b for emitting light of the second color (for example, green light) may be disposed on the pixel electrodes PE2a and PE2b of the second pixel PX2 exposed by the pixel openings PO2a and PO2b. The light emitting layers EL3a and EL3b emitting for light of the third color (for example, blue light) may be disposed on the pixel electrodes PE3a and PE3b of the third pixel PX3 exposed by the pixel openings PO3a and PO3b. Each of the light emitting layers EL1a, EL1b, EL2a, EL2b, EL3a, EL3b may include at least one selected from an organic light emitting material and a quantum dot.

The common electrode CE including a conductive material may be disposed on the light emitting layers EL1a, EL1b, EL2a, EL2b, EL3a, EL3b. In an embodiment, the common electrode CE may continuously extend over the plurality of pixels on the display area DA.

The encapsulation layer ENC may be disposed on the common electrode. The encapsulation layer ENC may include at least one inorganic encapsulation layer and at least one organic encapsulation layer.

The touch insulation layer TIL may be disposed on the encapsulation layer ENC. In an embodiment, the touch insulation layer TIL may include an inorganic insulation material.

The touch electrode layer TE may be disposed on the touch insulation layer TIL. The touch electrode layer TE may include a conductive material. In an embodiment, the touch electrode layer TE may be disposed to not overlap the light emitting layers EL1a, EL1b, EL2a, EL2b, EL3a, and EL3b. In an embodiment, for example, the touch electrode layer TE may include a first touch electrode layer, an inorganic insulation layer covering the first touch electrode layer, and a second touch electrode layer disposed on the inorganic insulation layer.

The overcoating layer OC may cover the touch electrode layer TE. In an embodiment, the overcoating layer OC may include an organic insulation material.

The light blocking element BM may be disposed on the pixel unit UPX, and may block a portion of light emitted from each of the first to third pixels PX1, PX2, and PX3 to adjust viewing angle. In an embodiment, the light blocking element BM may be disposed on the overcoating layer OC.

In a plan view, the light blocking element BM may surround each of the first light emitting element LED1a and the second light emitting element LED 1b. In an embodiment, as shown in FIG. 3 and FIG. 4, in a plan view, a first distance d1 between an edge (for example, right edge of the pixel opening PO1a) in the first direction DR1 of the first light emitting element LED1a of the first pixel PX1 and the light blocking element BM may be less than a second distance d2 between the edge (for example, left edge of the pixel opening PO1a) in the second direction DR2 of the first light emitting element LED1a of the first pixel PX1 and the light blocking element BM. Accordingly, the light blocking element BM may block a portion of light emitted from the first light emitting element LED1a and traveling in the first direction DR1.

In an embodiment, as shown in FIG. 3 and FIG. 5, in a plan view, a third distance d3 between an edge (for example, right edge of the pixel opening PO1b) in the first direction DR1 of the second light emitting element LED1b of the first pixel PX1 and the light blocking element BM may be greater than a distance d4 between an edge (for example, left edge of the pixel opening PO1b) in the second direction DR2 of the second light emitting element LED1b of the first pixel PX1 and the light blocking element BM. Accordingly, the light blocking element BM may block a portion of light emitted from the second light emitting element LED1b and traveling in the second direction DR2.

In such an embodiment, the light blocking element BM may block a portion of light emitted from each of the first light emitting elements LED2a and LED3a of the second and third pixels PX2 and PX3 which travels in the first direction DR1, and block a portion of light emitted from each of the second light emitting elements LED2b and LED3b of the second and third pixels PX2 and PX3 which travels in the second direction DR2.

In an embodiment, when displaying an image in a mode which limits viewing angle in the first direction DR1, the emission driver 600 may apply the first emission signal EM1 having an activation level to the plurality of first emission lines EL1, and may apply the second emission signal EM2 having an inactivation level to the plurality of second emission lines EL2. In this case, the first light emitting elements LED1a, LED2a, and LED3a may be turned on, and the second light emitting elements LED1b, LED2b, and LED3b may be turned off. The light emitting element BM may block a portion of light emitted from each of the first light emitting elements LED1a, LED2a, and LED3a and traveling in the first direction DR1. Accordingly, an image may not be viewed in the first direction DR1 (e.g., from a side in the first direction DR1) of the display panel 100.

When displaying an image in a mode which limits viewing angle in the second direction DR2, the emission driver 600 may apply the first emission signal EM1 having an inactivation level to the plurality of first emission lines EL1, and may apply the second emission signal EM2 having an activation level to the plurality of second emission lines EL2. In this case, the first light emitting elements LED1a, LED2a, and LED3a may be turned off, and the second light emitting elements LED1b, LED2b, and LED3b may be turned on. The light blocking element BM may block a portion of light emitted from each of the second light emitting elements LED1b, LED2b, and LED3b and traveling in the second direction DR2. Accordingly, an image may not be viewed in the second direction DR2 of the display panel 100.

When displaying an image in a mode which does not limit viewing angle, the emission driver 600 may apply the first emission signal EM1 having an activation level to the plurality of first emission lines EL1, and the second emission signal EM2 having an activation level to the plurality of second emission lines EL2. In this case, the first light emitting elements LED1a, LED2a, and LED3a and the second light emitting elements LED1b, LED2b, and LED3b may be turned on. Accordingly, an image may be viewed in the first direction DR1 and the second direction DR2 of the display panel 100.

According to embodiments, the display panel 100 may display an image in a wide viewing angle or a narrow viewing angle in which a viewing angle in a specific direction is limited based on an input mode. Accordingly, user's privacy may be protected if desired. In such embodiments, even when an image is displayed at a narrow viewing angle in which a viewing angle in a specific direction is limited, resolution of the image may not be reduced.

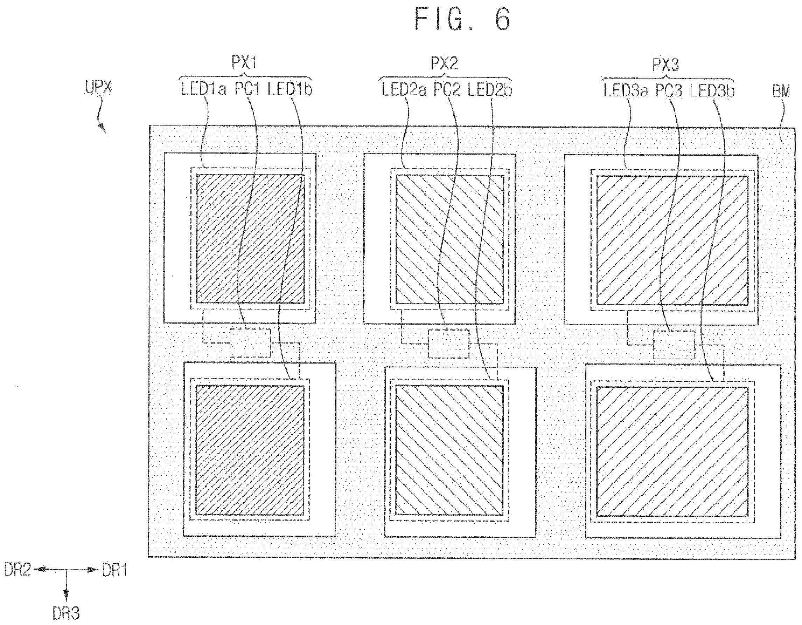

FIG. 6, FIG. 7, and FIG. 8 are plan views illustrating alternative embodiments of a pixel unit and a light blocking element included in the display device of FIG. 1.

Referring to FIG. 6, FIG. 7, and FIG. 8, according to embodiments, arrangement of the first light emitting elements LED1a, LED2a, and LED3a and arrangement of the second light emitting elements LED1b, LED2b, and LED3b may be variously changed.

In an alternative embodiment, as shown in FIG. 6, in a plan view, the first light emitting element LED1a of the first pixel PX1, the first light emitting element LED2a of the second pixel PX2, and the first light emitting element LED3a of the third pixel PX3 may be sequentially disposed along the first direction DR1. The second light emitting element LED1b of the first pixel PX1 may be disposed in the third direction DR3 of the first light emitting element LED1a of the first pixel PX1, the second light emitting element LED2b of the second pixel PX2 may be disposed in the third direction DR3 of the first light emitting element LED2a of the second pixel PX2, and the third light emitting element LED3b of the third pixel PX3 may be disposed in the third direction DR3 of the first light emitting element LED3a of the third pixel PX3.

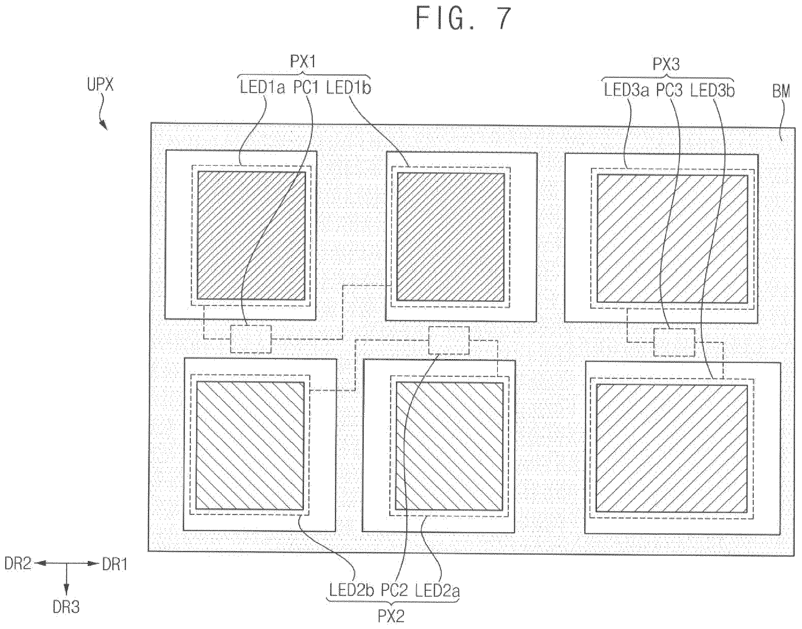

In another alternative embodiment, as shown in FIG. 7, in a plan view, the first light emitting element LED1a of the first pixel PX1, the second light emitting element LED1b of the first pixel PX1, and the first light emitting element LED3a of the third pixel PX3 may be sequentially disposed along the first direction DR1. The second light emitting element LED2b of the second pixel PX2 may be disposed in third direction DR3 of the first light emitting element LED1a of the first pixel PX1, the first light emitting element LED2a of the second pixel PX2 may be disposed in the third direction DR3 of the second light emitting element LED 1 b of the first pixel PX1, and the second light emitting element LED3b of the third pixel PX3 may be disposed in the third direction DR3 of the first light emitting element LED3a of the third pixel PX3.

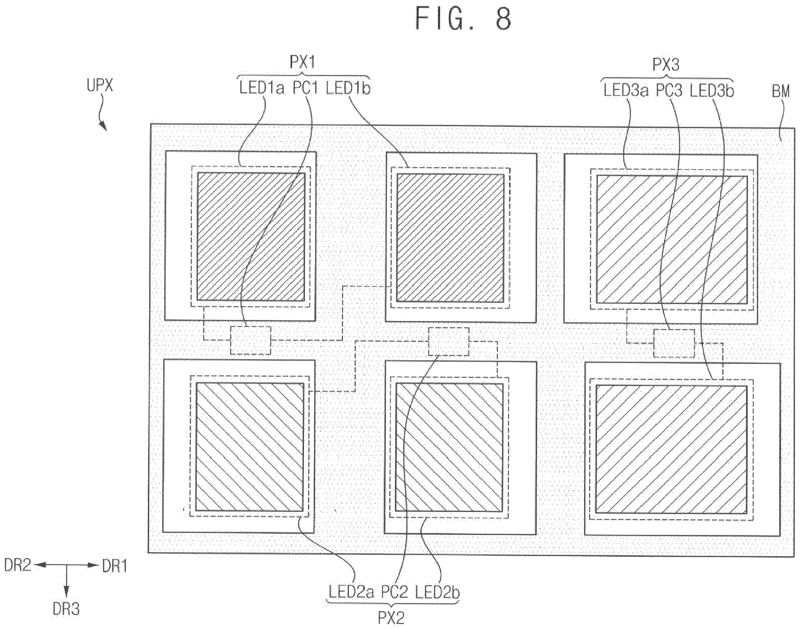

In another alternative embodiment, as shown in FIG. 8, in a plan view, the first light emitting element LED1a of the first pixel PX1, the second light emitting element LED1b of the first pixel PX1, and the first light emitting element LED3a of the third pixel PX1 may be sequentially disposed along the first direction DR1. The first light emitting element LED2a of the second pixel PX2 may be disposed in the third direction DR3 of the first light emitting element LED1a of the first pixel PX1, the second light emitting element LED2b of the second pixel PX2 may be disposed in the third direction DR3 of the second light emitting element LED1b of the first pixel PX1, and the second light emitting element LED3b of the third pixel PX3 may be disposed in the third direction DR3 of the first light emitting element LED3a of the third pixel PX3. The embodiment shown in FIG. 8 is substantially the same as the embodiment shown in FIG. 7 except for the light blocking element BM.

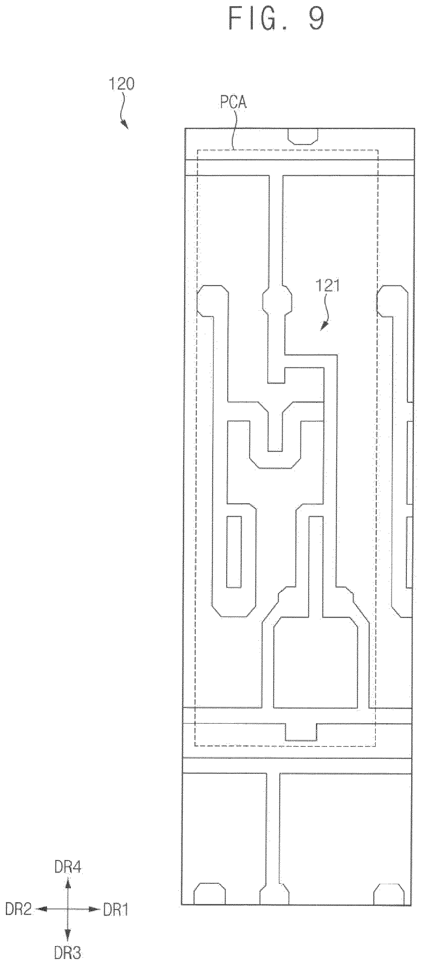

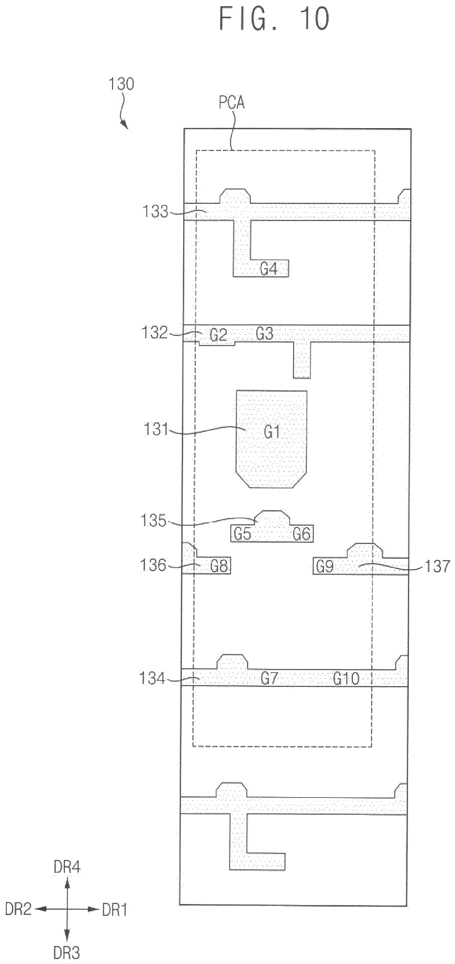

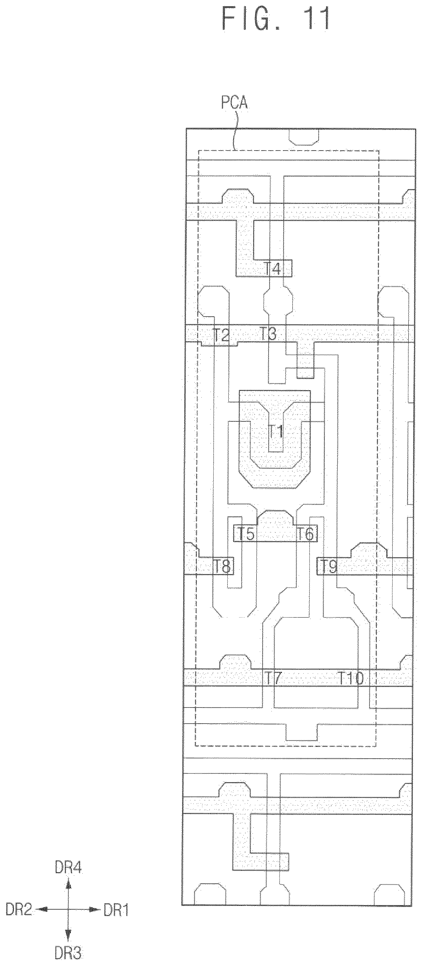

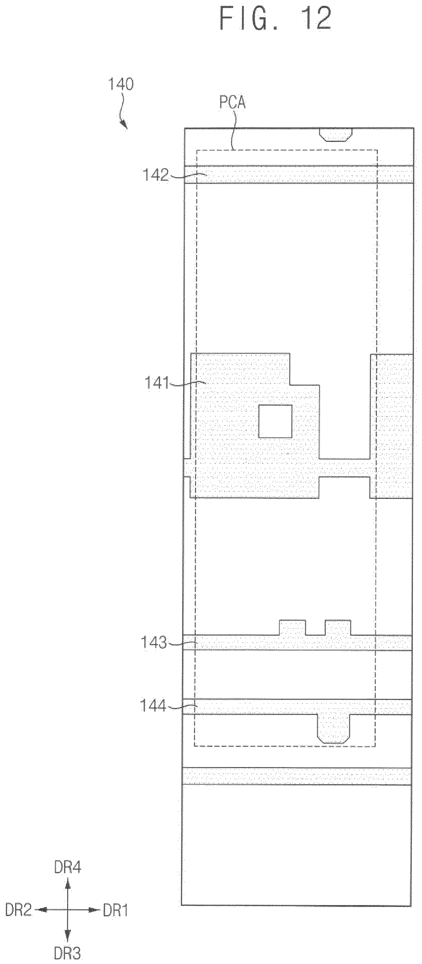

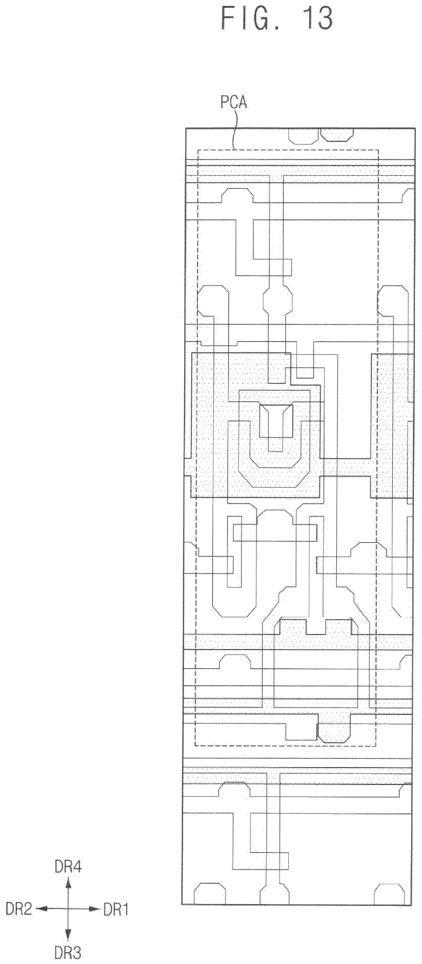

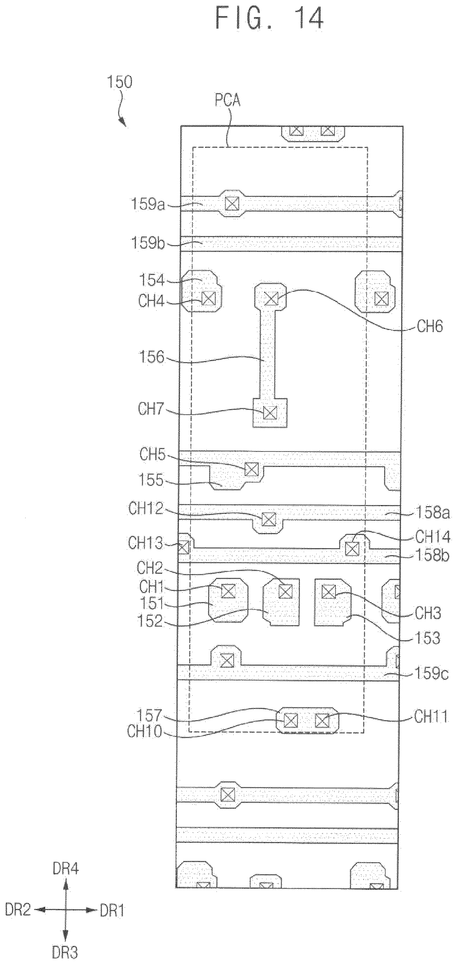

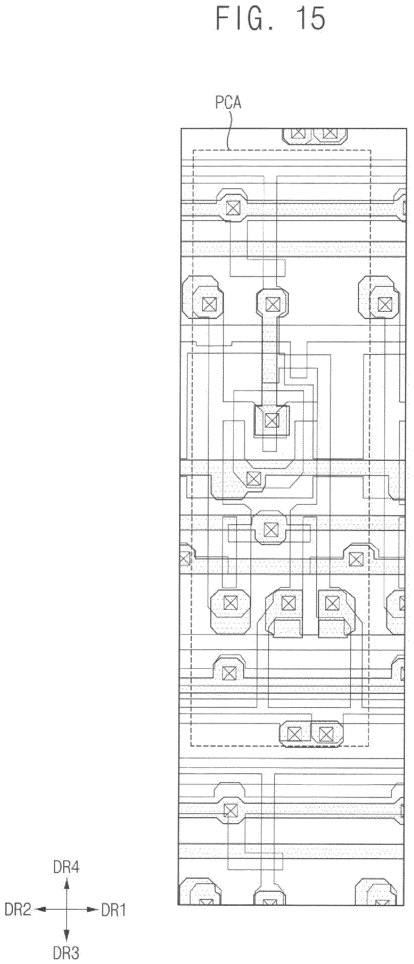

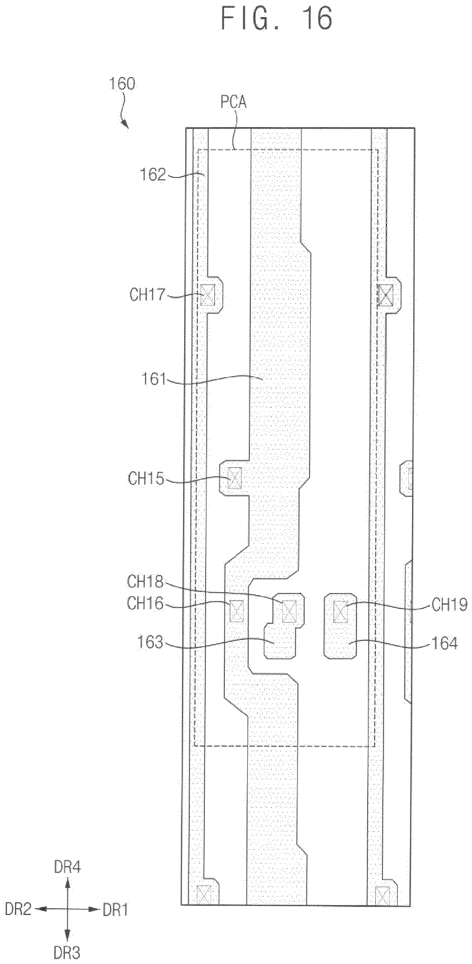

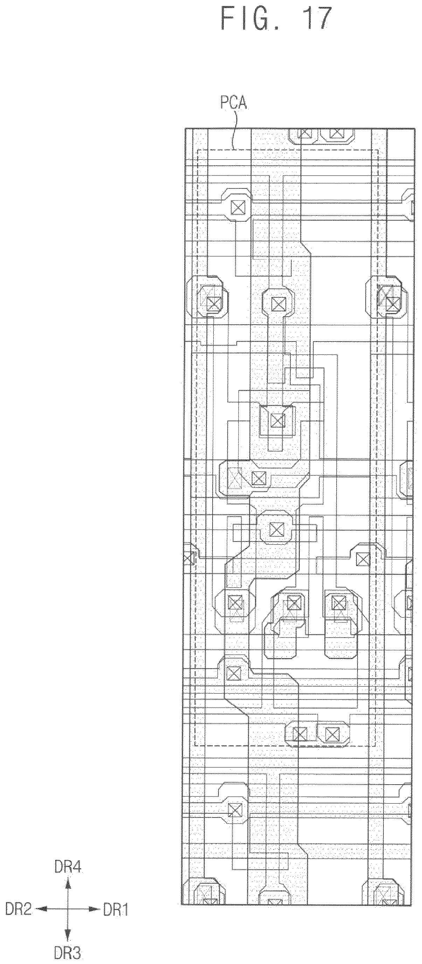

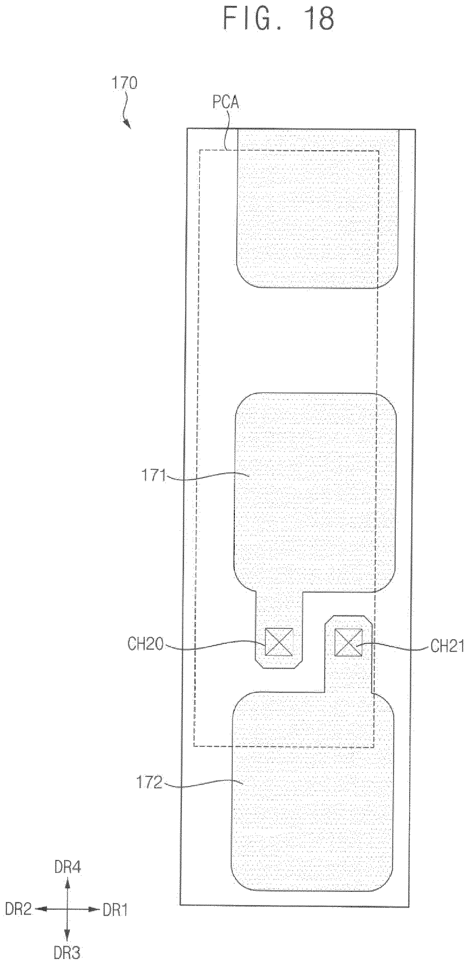

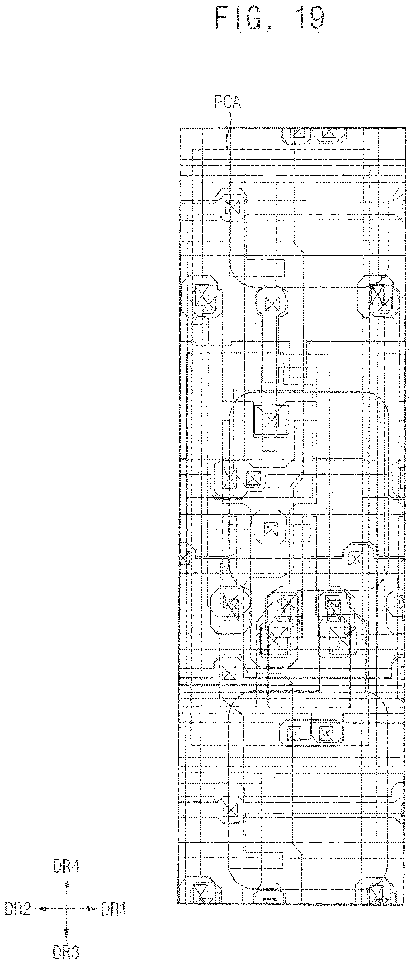

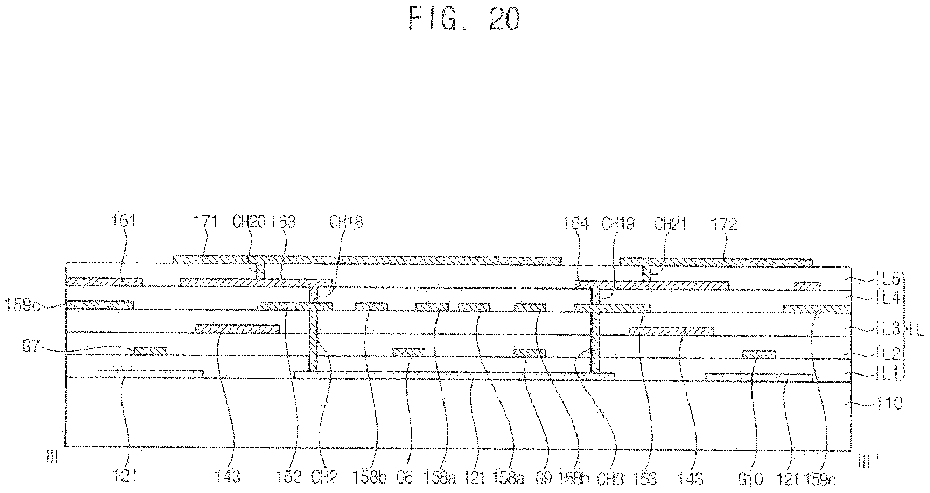

FIG. 9, FIG. 10, FIG. 11, FIG. 12, FIG. 13, FIG. 14, FIG. 15, FIG. 16, FIG. 17, FIG. 18, and FIG. 19 are diagrams illustrating layers of the pixel of FIG. 2. FIG. 20 is a cross-sectional view taken along line III-III' of FIG. 19.

Hereinafter, structure of each of the plurality of pixels PX will be described with reference to FIG. 9 to FIG. 20. FIG. 9 to FIG. 20 may be correspond to any one of the first to third pixels PX1, PX2, and PX3 of FIG. 3.

Referring to FIG. 2 and FIG. 9 to FIG. 20, in an embodiment, each of the plurality of pixels PX included in the display panel 100 may include an active layer 120, a first conductive layer 130, a second conductive layer 140, a third conductive layer 150, a fourth conductive layer 160, a fifth conductive layer 170, a light emitting layer, and a sixth conductive layer disposed on the substrate 110.

The substrate 110 may include a plurality of pixel circuit areas PCA. The pixel circuit PC may be disposed in each of the plurality of pixel circuit area PCA.

The active layer 120 may be disposed on the substrate 110. The active layer 120 may include an active pattern 121 disposed in the pixel circuit area PCA. The active layer 120 may include oxide semiconductor, silicon semiconductor, organic semiconductor, etc. In an embodiment, for example, oxide semiconductor may include at least one selected from In, Ga, Sn, Zr, V, Hf, Cd, Ge, Cr, Ti, and Zn. The silicon semiconductor may include an amorphous silicon, polycrystalline silicon, etc.

In an embodiment, a buffer layer may be disposed between the substrate 110 and the active layer 120. The buffer layer may block impurities such as oxygen and moisture from diffusing into the active layer 120. In addition, the buffer layer may provide a substantially flat surface on the substrate 110. The buffer layer may include an inorganic insulation material such as silicon compound, metal oxide, etc. In an embodiment, the inorganic insulation material of the buffer layer may include silicon oxide, silicon nitride, silicon oxynitride, silicon carbonitride, aluminum oxide, aluminum nitride, tantalum oxide, hafnium oxide, zirconium oxide or titanium oxide, for example. These may be used alone or in combination with each other. The buffer layer may have a single layer structure or a multi-layer structure including a plurality of insulation layers. In an alternative embodiment, the buffer layer may be omitted.

The first conductive layer 130 may be disposed on the active layer 120. The first conductive layer 130 may include a conductive material such as metal, alloy, conductive metal nitride, conductive metal oxide, transparent conductive material, etc. In an embodiment, the conductive material of the first conductive layer 130 may include Au, Ag, Al, Pt, Ni, Ti, Pd, Mg, Ca, Li, Cr, Ta, W, Cu, Mo, Sc, Nd, Ir, alloy including Al, alloy including Ag, alloy including Cu, alloy including Mo, aluminum nitride, tungsten nitride, titanium nitride, chromium nitride, tantalum nitride, strontium ruthenium oxide, zinc oxide, indium tin oxide, tin oxide, indium oxide, gallium oxide or indium zinc oxide, for example. These may be used alone or in combination with each other.

A first insulation layer IL1 may be disposed between the active layer 120 and the first conductive layer 130. The first insulation layer IL1 may include an inorganic insulation layer.

The first conductive layer 130 may include a first conductive pattern 131, a data input gate line 132, a data initialization gate line 133, a light emitting element initialization line 134, a second conductive pattern 135, a third conductive pattern 136, and the fourth conductive pattern 137.

A portion of the first conductive pattern 131 overlapping the active pattern 121 may be a gate electrode G1 of the first transistor T1. In addition, a portion of the active pattern 121 overlapping the gate electrode G1 may be a channel portion of the first transistor T1. Accordingly, the active pattern 121 and the gate electrode G1 may define the first transistor T1.

The data input gate line 132 may extend in the first direction DR1. The data input gate line 132 may be spaced apart from the first conductive pattern 131 in a fourth direction DR4 opposite to the third direction DR3. The data input gate signal GW may be applied to the data input gate line 132.

A portion of the data input gate line 132 overlapping the active pattern 121 may be a gate electrode G2 of the second transistor T2, and another portion of the data input gate line 132 overlapping the active pattern 121 may be a gate electrode G3 of the third transistor T3. In addition, a portion of the active pattern 121 overlapping the gate electrode G2 may be a channel portion of the second transistor T2, and a portion of the active pattern 121 overlapping the gate electrode G3 may be a channel portion of the third transistor T3. Accordingly, the active pattern 121 and the gate electrode G2 may define the second transistor T2, and the active pattern 121 and the gate electrode G3 may define the third transistor T3.

The data initialization gate line 133 may extend in the first direction DR1. The data initialization gate line 133 may be spaced apart from the data input gate line 132 in the fourth direction DR4. The data initialization gate signal GI may be applied to the data initialization gate line 133.

A portion of the data initialization gate line 133 overlapping the active pattern 121 may be a gate electrode G4 of the fourth transistor T4. In addition, a portion of the active pattern 121 overlapping the gate electrode G4 may be a channel portion of the fourth transistor T4. Accordingly, the active pattern 121 and the gate electrode G4 may define the fourth transistor T4.

The light emitting element initialization line 134 may extend in the first direction DR1. The light emitting element initialization line 134 may be spaced apart from the first conductive pattern 131 in the third direction DR3. The light emitting element initialization signal GB may be applied to the light emitting element initialization line 134.

A portion of the light emitting element initialization line 134 overlapping the active pattern 121 may be a gate electrode G7 of the seventh transistor T7, and another portion of the light emitting element initialization line 134 overlapping the active pattern 121 may be a gate electrode G10 of the tenth transistor T10. In addition, a portion of the active pattern 121 overlapping the gate electrode G7 may be a channel portion of the seventh transistor T7, and a portion of the active pattern 121 overlapping the gate electrode G10 may be a channel portion of the tenth transistor T10. Accordingly, the active pattern 121 and the gate electrode G7 may define the seventh transistor T7, and the active pattern 121 and the gate electrode G10 may define the tenth transistor T10.

The second conductive pattern 135, the third conductive pattern 136, and the fourth conductive pattern 137 may be disposed between the first conductive pattern 131 and the light emitting element initialization line 134. The second conductive pattern 135, the third conductive pattern 136, and the fourth conductive pattern 137 may be spaced apart from each other. As described later, the first emission signal EM1 may be applied to the second conductive pattern 135, and the second emission signal EM2 may be applied to the third conductive pattern 136 and the fourth conductive pattern 137.

A portion of the second conductive pattern 135 overlapping the active pattern 121 may be a gate electrode G5 of the fifth transistor T5, and another portion of the second conductive pattern 135 overlapping the active pattern 121 may be a gate electrode G6 of the sixth transistor T6. In addition, a portion of the active pattern 121 overlapping the gate electrode G5 may be a channel portion of the fifth transistor T5, and a portion of the active pattern 121 overlapping the gate electrode G6 may be a channel portion of the sixth transistor T6. Accordingly, the active pattern 121 and the gate electrode G5 may define the fifth transistor T5, and the active pattern 121 and the gate electrode G5 may define the sixth transistor T6.

A portion of the third conductive pattern 136 overlapping the active pattern 121 may be a gate electrode G8 of the eight transistor T8. In addition, a portion of the active pattern 121 overlapping the gate electrode G8 may be a channel portion of the eight transistor T8. Accordingly, the active pattern 121 and the gate electrode G8 may define the eight transistor T8.

A portion of the fourth conductive pattern 137 overlapping the active pattern 121 may be a gate electrode G9 of the ninth transistor T9. In addition, a portion of the active pattern 121 overlapping the gate electrode G9 may be a channel portion of the ninth transistor T9. Accordingly, the active pattern 121 and the gate electrode G9 may define the ninth transistor T9.

The second conductive layer 140 may be disposed on the first conductive layer 130. The second conductive layer 140 may include a conductive material.

A second insulation layer IL2 may be disposed between the first conductive layer 130 and the second conductive layer 140. The second insulation layer IL2 may be an inorganic insulation material.

The second conductive layer 140 may include a fifth conductive pattern 141, a first initialization line 142, a repair line 143, and a second initialization line 144.

The fifth conductive pattern 141 may overlap the first conductive pattern 131. The first conductive pattern 131 and the fifth conductive pattern 141 may define the storage capacitor CST.

The first initialization line 142 may extend in the first direction DR1. The first initialization line 142 may be spaced apart from the fifth conductive pattern 141 in the fourth direction DR4. The first initialization signal VINT may be applied to the first initialization line 142.

The repair line 143 may extend in the first direction DR1. The repair line 143 may be spaced apart from the fifth conductive pattern 141 in the third direction DR3.

The second initialization line 144 may extend in the first direction DR1. The second initialization line 144 may be spaced apart from the repair line 143 in the third direction DR3. The second initialization signal VAINT may be applied to the second initialization line 144.

The third conductive layer 150 may be disposed on the second conductive layer 140. The third conductive layer 150 may include a conductive material.

A third insulation layer IL3 may be disposed between the second conductive layer 140 and the third conductive layer 150. The third insulation layer IL3 may include an inorganic insulation material.

The third conductive layer 150 may include a first contact pattern 151, a second contact pattern 152, a third contact pattern 153, a fourth contact pattern 154, a fifth contact pattern 155, a first connection pattern 156, a second connection pattern, a third connection pattern 157, a first emission line 158a, and a second emission line 158b.

The first contact pattern 151 may be connected to the active pattern 121 through a first contact hole CH1. Accordingly, the first contact pattern 151 may be electrically connected to the fifth transistor T5 and the eight transistor T8.

The second contact pattern 152 may be connected to the active pattern 121 through a second contact hole CH2. Accordingly, the second contact pattern 152 may be electrically connected to the sixth transistor T6 and the seventh transistor T7.

The third contact pattern 153 may be connected to the active pattern 121 through a third contact hole CH3. Accordingly, the third contact pattern 153 may be electrically connected to the ninth transistor T9 and the tenth transistor T10.

The fourth contact pattern 154 may be connected to the active pattern 121 through a fourth contact hole CH4. Accordingly, the fourth contact pattern 154 may be connected to the second transistor T2.

The fifth contact pattern 155 may be connected to the fifth conductive pattern 141 through a fifth contact hole CH5. Accordingly, the fifth contact pattern 155 may be electrically connected to the storage capacitor CST.

The first connection pattern 156 may be connected to the active pattern 121 through a sixth contact hole CH6, and may be connected to the active pattern 121 through a seventh contact hole CH7. Accordingly, the first connection pattern 156 may connect the active pattern 121 and the first conductive pattern 131 to each other. The storage capacitor CST may be electrically connected to the fourth transistor T4 by the first connection pattern 156.

The second connection pattern (not shown) may be connected to the active pattern through an eight contact hole, and may be connected to the first initialization line 142 through a ninth contact hole. Accordingly, the second connection pattern may connect the active pattern 121 and the first initialization line 142 to each other. The first initialization line 142 may be electrically connected to the fourth transistor T4 by the second connection pattern.

The third connection pattern 157 may be connected to the active pattern 121 through a tenth contact hole CH10, and may be connected to the second initialization line 144 through an eleventh contact hole CH11. Accordingly, the third connection pattern 157 may connect the active pattern 121 and the second initialization line 144 to each other. The second initialization line 144 may be electrically connected to the seventh transistor T7 and the tenth transistor T10 by the third connection pattern 157.

In an embodiment, the second connection pattern may be included in one of three pixels included in one pixel unit UPX, and the third connection pattern 157 may be included in other one of the three pixels.

The first emission line 158a may extend in the first direction DR1. The first emission signal EM1 may be applied to the first emission line 158a. The first emission line 158a may be connected to the second conductive pattern 135 through a twelfth contact hole CH12. Accordingly, the first emission line 158a may be electrically connected to the fifth transistor T5 and the sixth transistor T6 by the second conductive pattern 135.

The second emission line 158b may extend in the first direction DR1. The second emission signal EM2 may be applied to the second emission line 158b. The second emission line 158b may be connected to the third conductive pattern 136 through a thirteenth contact hole CH13, and may be connected to the fourth conductive pattern 137 through a fourteenth contact hole CH14. Accordingly, the first emission line 158a may be electrically connected to the eight transistor T8 by the third conductive pattern 136, and may be electrically connected to the ninth transistor T9 by the fourth conductive pattern 137. In such an embodiment, the first to fourteenth contact holes CH1 to CH14 may be holes defined in the insulation structure IL, e.g., through the first to third insulation layers IL1 to IL3.

In an embodiment, the third conductive layer 150 may further include a plurality of gate signal transmission lines 159a, 159b, and 159c. Each of the plurality of gate signal transmission lines 159a, 159b, and 159c may extend in the first direction D1. Each of the gate signal transmission lines 159a, 159b, and 159c may be connected to the data input gate line 132, the data initialization gate line 133, and the light emitting element initialization line 134 through a contact hole defined in the insulation structure IL.

The fourth conductive layer 160 may be disposed on the third conductive layer 150. The fourth conductive layer 160 may include a conductive material.

A fourth insulation layer IL4 may be disposed between the third conductive layer 150 and the fourth conductive layer 160. The fourth insulation layer IL4 may include an inorganic insulation material.

The fourth conductive layer 160 may include a power voltage line 161, a data line 162, a sixth contact pattern 163, and a seventh contact pattern 164.

The power voltage line 161 may extend in the third direction DR3. The high power voltage ELVDD may be applied to the power voltage line 161. The power voltage line 161 may provide the high power voltage ELVDD to the pixel circuit PC.

The power voltage line 161 may be connected to the fifth contact pattern 155 through a fifteenth contact hole CH15, and may be connected to the first contact pattern 151 through a sixteenth contact hole CH16. Accordingly, the power voltage line 161 may be connected to the storage capacitor CST by the fifth contact pattern 155, and may be connected to the fifth transistor T5 and the eight transistor T8 by the first contact pattern 151.

The data line 162 may extend in the third direction DR3. The data line 162 may be spaced apart from the power voltage line 161 in the second direction DR2. The data voltage VDATA may be applied to the data line 162.

The data line 162 may be connected to the fourth contact pattern 154 through a seventeenth contact hole CH17. Accordingly, the data line 162 may be electrically connected to the second transistor T2 by the fourth contact pattern 154.

The sixth contact pattern 163 may be connected to the second contact pattern 152 through an eighteenth contact hole CH18. Accordingly, the sixth contact pattern 163 may be electrically connected to the sixth transistor T6 and the seventh transistor T7 by the second contact pattern 152.

The seventh contact pattern 164 may be connected to the third contact pattern 153 through a nineteenth contact hole CH19. Accordingly, the seventh contact pattern 164 may be electrically connected to the ninth transistor T9 and the tenth transistor T10 by the third contact pattern 153. In such an embodiment, the fifteenth to nineteenth contact holes CH15 to CH19 may be holes defined in the insulation structure IL, e.g., through the fourth insulation layer IL4.

The fifth conductive layer 170 may be disposed on the fourth conductive layer 160. The fifth conductive layer 170 may include a conductive material.

The fifth insulation layer IL5 may be disposed between the fourth conductive layer 160 and the fifth conductive layer 170. The fifth insulation layer IL5 may include an inorganic insulation material and/or an organic insulation material. In an embodiment, for example, the first to fifth insulation layers IL1, IL2, IL3, IL4, and IL5 may define the insulation structure IL.

The fifth conductive layer 170 may include a sixth conductive pattern 171 and a seventh conductive pattern 172. The sixth conductive pattern 171 may be physically spaced apart from the seventh conductive pattern 172. The sixth conductive pattern 171 may be the first electrode (for example, a pixel electrode) of the first light emitting element LEDa, and the seventh conductive pattern 172 may be the first electrode (for example, a pixel electrode) of the second light emitting element LEDb.

The sixth conductive pattern 171 may be connected to the sixth contact pattern 163 through a twentieth contact hole CH20. Accordingly, the sixth conductive pattern 171 may be electrically connected to the sixth transistor T6 and the seventh transistor T7 by the sixth contact pattern 163 and the second contact pattern 152.

The seventh conductive pattern 172 may be connected to the seventh contact pattern 164 through a twenty-first contact hole CH21. Accordingly, the seventh conductive pattern 172 may be electrically connected to the ninth transistor T9 and the tenth transistor T10 by the seventh contact pattern 164 and the third contact pattern 153. In such an embodiment, the twentieth and twenty-first contact hole CH20 and CH21 may be holes defined in the insulation structure IL, e.g., through the fifth insulation layer IL5.A pixel defining layer (for example, PDL of FIG. 4) may be disposed on the fifth conductive layer 170. The pixel defining layer may define a pixel opening exposing at least a portion of each of the sixth conductive pattern 171 and the seventh conductive pattern 172.

The light emitting layer may be disposed on the fifth conductive layer 170. The light emitting layer may include a first light emitting pattern disposed on the sixth conductive pattern 171 exposed by the pixel opening and a second light emitting pattern disposed on the seventh conductive pattern 172 exposed by the pixel opening. In an embodiment, for example, the first light emitting pattern and the second light emitting pattern may have a shape corresponding to the sixth conductive pattern 171 and the seventh conductive pattern 172. The first light emitting pattern and the second light emitting layer may emit light of the same color.

The sixth conductive layer may be disposed on the light emitting layer. In an embodiment, for example, the sixth conductive layer may be entirely disposed on the pixel circuit area PCA. The sixth conductive layer may be the second electrode (for example, common electrode) of the first light emitting element LEDa and the second electrode (for example, common electrode) of the second light emitting element LEDb. The sixth conductive pattern 171, the first light emitting pattern, and the sixth conductive layer may define the first light emitting element LEDa, and the seventh conductive pattern 172, the second light emitting pattern, and the sixth conductive layer may define the second light emitting element LEDb.

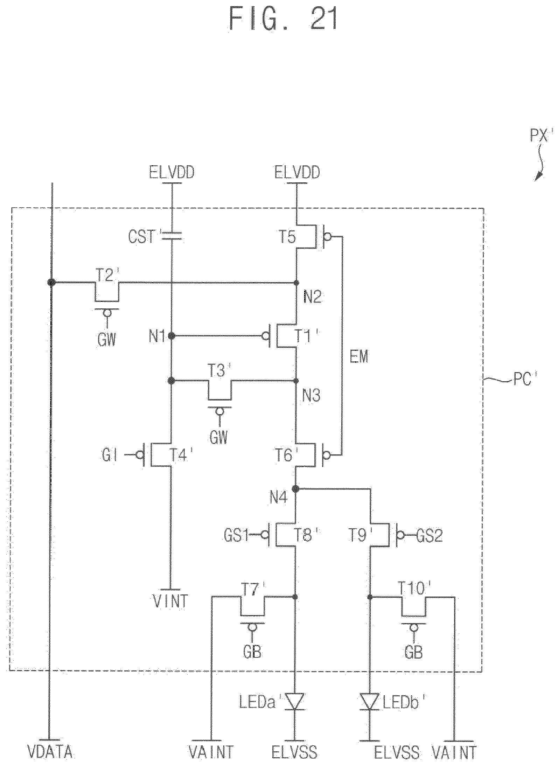

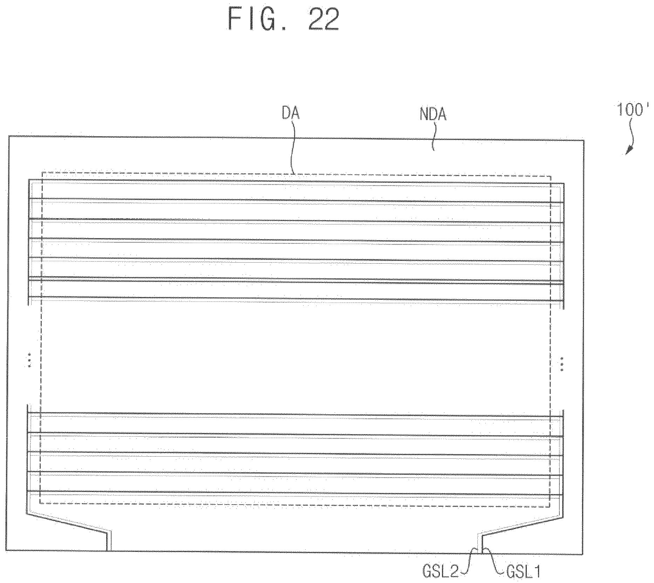

FIG. 21 is a circuit diagram illustrating a pixel included in a display device according to an alternative embodiment. FIG. 22 is a plan view illustrating a display panel according to an alternative embodiment.

Referring to FIG. 21 and FIG. 22, in an alternative embodiment, a display device may include a display panel 100' and a panel driver. Each of a plurality of pixels PX' included in the display panel 100' may include a pixel circuit PC', a first light emitting element LEDa', and a second light emitting element LEDb'. The pixel circuit PC' may provide driving current to the first light emitting element LEDa' and the second light emitting element LEDb'. The first light emitting element LEDa' and the second light emitting element LEDb' may emit light of the same color based on the driving current.

In an embodiment, the pixel circuit PC' may include first to tenth transistors T1', T2', T3', T4', T5', T6', T7', T8'. T9', and T10', and the storage capacitor CST', but the invention is not limited thereto.

The first transistor T1' may include a gate electrode connected to a first node N1, a first electrode connected to a second node N2, and a second electrode connected to a third node N3. In an embodiment, the first transistor T1' may be a P-type thin film transistor.

The second transistor T2' may include a gate electrode to which a data input gate signal GW is applied, a first electrode to which a data voltage VDATA is applied, and a second electrode connected to the second node N2. In an embodiment, the second transistor T2' may be a P-type thin film transistor.

The third transistor T3' may include a gate electrode to which the data input gate signal GW is applied, a first electrode connected to the first node N1, and a second electrode connected to the third node N3. In an embodiment, the third transistor T3' may be a P-type thin film transistor.

The fourth transistor T4' may include a gate electrode to which the data initialization gate signal GI is applied, a first electrode to which a first initialization signal VINT is applied, and a second electrode connected to the first node N1. In an embodiment, the fourth transistor T4' may be a P-type thin film transistor.

The fifth transistor T5' may include a gate electrode to which an emission signal EM is applied, a first electrode to which a high power voltage ELVDD is applied, and a second electrode connected to the second node N2. In an embodiment, the fifth transistor T5' may be a P-type thin film transistor.

The sixth transistor T6' may include a gate electrode to which the emission signal EM is applied, a first electrode connected to the third node N3, and a second electrode connected to a fourth node N4. In an embodiment, the sixth transistor T6' may be a P-type thin film transistor.

The seventh transistor T7' may include a gate electrode to which a light emitting element initialization gate signal GB is applied, a first electrode to which a second initialization signal VAITN is applied, and a second electrode connected to a first electrode (for example, a pixel electrode) of the first light emitting element LEDa'. In an embodiment, the seventh transistor T7' may be a P-type thin film transistor.

The eight transistor T8' may include a gate electrode to which a first global signal GS1 is applied, a first electrode connected to the fourth node N4, and a second electrode connected to the first electrode of the first light emitting element LEDa'. In an embodiment, the eight transistor T8' may be a P-type thin film transistor.

The ninth transistor T9' may include a gate electrode to which a second global signal GS2 is applied, a first electrode connected to the fourth node N4, and a second electrode connected to a first electrode (for example, the pixel electrode) of the second light emitting element LEDb'. In an embodiment, the ninth transistor T9' may be a P-type thin film transistor.

The tenth transistor T10' may be a gate electrode to which a light emitting element initialization gate signal GB is applied, a first electrode to which the second initialization signal VAINT is applied, and a second electrode connected to the first electrode of the second light emitting element LEDb'. In an embodiment, the tenth transistor T10' may be a P-type thin film transistor.

The storage capacitor CST' may include a first electrode to which the high power voltage ELVDD is applied and a second electrode connected to the first node N1.

The first light emitting element LEDa' may include the first electrode and a second electrode (for example, a common electrode) to which the low power voltage ELVSS is applied. Operation of the first light emitting element LEDa' may be controlled by the emission signal EM and the first global signal GS1. In an embodiment, for example, when the emission signal EM has an activation level, the fifth transistor T5' and the sixth transistor T6' may be turned on. In such an embodiment, the first transistor T1' may be turned on by the data voltage VDATA. In addition, when the first global signal GS1 has an activation level, the eight transistor T8' may be turned on. The driving current may flow in order of the fifth transistor T5', the first transistor T1', the sixth transistor T6', and the eight transistor T8' to drive the first light emitting element LEDa'.

The second light emitting element LEDb' may include the first electrode and a second electrode (for example, a common electrode) to which the low power voltage ELVSS is applied. Operation of the second light emitting element LEDb' may be controlled by the emission signal EM and the second global signal GS2. In an embodiment, for example, when the emission signal EM has an activation level, the fifth transistor T5' and the sixth transistor T6' may be turned on. In such an embodiment, the first transistor T1' may be turned on by the data voltage VDATA. In addition, when the second global signal GS2 has an activation level, the ninth transistor T9' may be turned on. The driving current may flow in order of the fifth transistor T5', the first transistor T1', the sixth transistor T6', and the ninth transistor T9' to drive the second light emitting element LEDb'.

In an embodiment, the first global signal GS1 for controlling operation of the first light emitting element LEDa' may be provided by the panel driver. The first global signal GS 1 may be provided to all of the plurality of pixels PX' in the display area DA by a first global signal line GSL1. In an embodiment, the first global signal line GSL1 may have a mesh form to be entirely disposed in the display area DA.

In an embodiment, the second global signal GS2 for controlling operation of the second light emitting element LEDb' may be provided by the panel driver. The second global signal GS2 may be provided to all of the plurality of pixels PX' in the display area DA by a second global signal line GSL2. In an embodiment, the second global signal line GSL2 may have a mesh form to be entirely disposed in the display area DA. In an embodiment, the first global signal line GSL1 and the second global signal line GSL2 may be disposed in different layers from each other.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display panel, comprising:
a pixel unit comprising a plurality of pixels which emit light of different colors from each other; and
a light blocking element disposed on the pixel unit, wherein the light blocking element is configured to block a portion of light emitted from each of the plurality of pixels, wherein,
each of the plurality of pixels comprises:
a pixel circuit;
a first light emitting element electrically connected to the pixel circuit; and
a second light emitting element electrically connected to the pixel circuit, wherein the second light emitting element emits light of the same color as the light emitted from the first light emitting element, wherein,
the light blocking element is configured to block a portion of light emitted from the first light emitting element and traveling in a first direction, and configured to block a portion of light emitted from the second light emitting element and traveling in a second direction opposite to the first direction.

2. The display panel of claim 1, wherein a pixel electrode of the first light emitting element is spaced apart from a pixel electrode of the second light emitting element.

3. The display panel of claim 1 or 2, wherein, in a plan view,
the light blocking element surrounds each of the first light emitting element and the second light emitting element, and
a first distance between an edge in the first direction of the first light emitting element and the light blocking element is less than a second distance between an edge in the second direction of the first light emitting element and the light blocking element, and
a third distance between an edge in the first direction of the second light emitting element and the light blocking element is greater than a fourth distance between an edge in the second direction of the second light emitting element and the light blocking element.

4. The display panel of any one of the preceding claims, wherein
the plurality of pixels comprises a first pixel, a second pixel, and a third pixel, and
a first light emitting element of the first pixel, a first light emitting element of the second pixel, and a first light emitting element of the third pixel are respectively placed at vertices of an imaginary triangle, wherein
a second light emitting element of the first pixel, a second light emitting element of the second pixel, and a second light emitting element of the third pixel are respectively placed at vertices of another imaginary triangle.

5. The display panel of any one of the preceding claims, wherein,
a first emission signal, which controls an operation of the first light emitting element, is configured to be applied to the pixel circuit, and
a second emission signal, which controls an operation of the second light emitting element, is configured to be applied to the pixel circuit.

6. The display panel of any one of the preceding claims, further comprising:
a first global signal line to which a first global signal is applied, wherein the first global signal line has a mesh shape, and the first global signal controls an operation of the first light emitting element; and
a second global signal line to which a second global signal is applied, wherein the second global signal line has a mesh shape, and the second global signal controls an operation of the second light emitting element.

7. A display device comprising:
a display panel according to any one of the preceding claims;
a gate driver configured to provide a gate signal to the display panel;
a data driver configured to provide a data voltage to the display panel; and
an emission driver configured to provide an emission signal to the display panel.
